# FASCICULE DE BREVET EUROPEEN

(11) **EP 4 073 426 B1**
(45) Date de publication et mention de la délivrance du brevet: **18.03.2026**
(21) Numéro de dépôt: 20820207.7
(22) Date de dépôt: 10.12.2020
(51) Int. Cl.: H05K 3/40, F21S 45/10, H05K 1/02, F21S 45/47

(54) **DISPOSITIF LUMINEUX D'UN VÉHICULE AUTOMOBILE**
BELEUCHTUNGSVORRICHTUNG FÜR EIN KRAFTFAHRZEUG
LIGHTING DEVICE FOR A MOTOR VEHICLE

(30) Priorité: 11.12.2019 FR 1914213
(43) Date de publication de la demande: 19.10.2022
(73) Titulaire: Valeo Vision, 93012 Bobigny Cedex (FR)
(72) Inventeur: DINANT, Franck, 93012 Bobigny (FR); SACCHET, Dirkie, 93012 Bobigny (FR)
(74) Mandataire: Valeo Visibility
(86) Numéro de dépôt international: PCT/EP2020/085526
(87) Numéro de publication internationale: WO 2021/116284

(56) Documents cités:
- EP-A1- 3 209 098
- EP-A1- 3 211 293
- DE-A1- 102007 036 939
- US-A1- 2011 157 844

## Description

La présente invention concerne un dispositif lumineux de véhicule automobile.

Il est connu un dispositif lumineux comprenant un substrat comportant des pistes électriques, une source lumineuse à semi-conducteur et une pièce formant masse, dans lequel ladite pièce formant masse est mise en contact électrique avec des pistes du substrat par l'intermédiaire d'une pièce rapportée possédant une partie flexible assurant le contact électrique entre des pistes du substrat et la pièce formant masse. Cela a pour effet technique d'éviter des décharges électrostatiques entre le substrat et la pièce formant masse, tout en évitant, grâce à la déformation de la partie flexible de la pièce rapportée, une déformation du substrat. Une telle déformation du substrat aurait pour effet un déplacement de la LED, ce qui se traduirait par une perte d'efficacité lumineuse. Cependant, cette pièce rapportée implique des coûts de fabrication du dispositif lumineux, en termes d'approvisionnement, de matière et de procédés d'assemblage. EP 3 209 098 A1 divulgue un dispositif lumineux connu de l'art antérieur.

L'invention a pour objet d'éliminer ces coûts de fabrication, tout en limitant un déplacement de la LED et/ou de la pièce optique et/ou une diminution de l'efficacité lumineuse.

A cet effet, l'invention a pour objet un dispositif lumineux d'un véhicule automobile, comportant :
- Une source lumineuse et/ou une pièce optique,
- Un substrat comportant des pistes électriques, ladite source lumineuse étant fixée sur ledit substrat,
- Une pièce formant une masse électrique pour lesdits pistes électriques.

Le substrat comporte une découpe formant une languette, des pistes électriques du substrat se prolongeant sur ladite languette, au moins une desdites pistes étant en contact électrique avec la pièce formant masse. Ce contact a pour effet d'éviter des décharges électrostatiques entre la pièce formant masse et le substrat.

Selon l'invention le contact entre le substrat et la pièce formant masse est maintenu grâce à une déformation élastique de la languette, de préférence en flexion, ce qui permet de garantir le contact malgré des tolérances larges de fabrication. On comprend par déformation élastique que cette déformation de la languette est réversible et que lorsque la contrainte d'appui de la languette sur le contact de la languette est levée, la pièce reprend sa forme initiale. Cela permet de réduire amplement un coût d'obtention du module lumineux.

Avantageusement, le substrat est un substrat rigide, par opposition aux substrats flexibles connus de l'homme du métier sous le nom de flex-PCB. De préférence, le substrat a un module élastique (dit module de Young) supérieur à 7 GPa, de préférence supérieur à 15 GPa, de préférence supérieur à 20 GPa, ce qui permet d'améliorer le maintien du contact entre le substrat et la pièce formant masse, en particulier de sorte que le contact est maintenu y compris dans l'environnement vibratoire automobile.

Avantageusement, le substrat a une épaisseur supérieure à 0,4 mm, de préférence supérieure à 0,8 mm, de préférence proche de 1mm ; une telle épaisseur permet de garantir une résistance mécanique suffisante pour que le substrat ce qui permet d'améliorer le maintien du contact entre le substrat et la pièce formant masse, en particulier de sorte que le contact est maintenu y compris dans l'environnement vibratoire automobile. On comprend qu'un substrat rigide et/ou épais contribue également à maintenir une hauteur précise de la source lumineuse et/ou de la pièce optique qu'il supporte. Avantageusement, le substrat a une épaisseur inférieure à 2 mm, de préférence inférieure ou égale à 1,6 mm, de préférence inférieur à 1,2 mm. Cela permet d'éviter des contraintes, notamment de cisaillement, trop élevées dans le substrat et des efforts trop importants sur les contacts de la languette et qui pourraient en dégrader la surface et la conductivité. De préférence, le substrat est un substrat rigide de type FR4, ou alternativement un substrat métallique isolé, par exemple un substrat en aluminium recouvert d'une couche diélectrique. Dans un mode de réalisation de réalisation préféré, le substrat est en FR4, a un module de Young supérieur à 20GPa, et a une épaisseur proche de 1mm.

La déformation liée au contact entre le substrat et la pièce formant masse est concentrée au niveau de la languette. De la sorte, les effets de cette déformation sur le reste du substrat sont donc limités. En particulier un déplacement de ladite source lumineuse et/ou pièce optique dans une direction perpendiculaire au plan du substrat, et/ou une perte d'efficacité lumineuse sont limités.

Par exemple, les déformations et déplacements résiduels du substrat ne provoquent pas de mouvement de la source lumineuse et/ou pièce optique impliquant une perte de performance du dispositif lumineux ; en particulier, une fonction réglementaire du dispositif lumineux est assurée malgré la déformation résiduelle.

Cet effet est particulièrement intéressant dans le cas où le dispositif lumineux comporte un système optique pour dévier un faisceau lumineux issu de la source lumineuse et/ou de la pièce optique, en particulier lorsque la position dudit système optique est indépendante des déformations du substrat. La déformation limitée du substrat permet alors qu'un faisceau lumineux issu de la source lumineuse et/ou de la pièce optique et dirigé vers ledit système optique soit correctement dévié par celui-ci. Une efficacité lumineuse du dispositif lumineux est donc encore améliorée.

Par ailleurs, le contact électrique entre la pièce formant masse et des pistes du substrat est établi sans l'utilisation d'une pièce rapportée. Les coûts de fabrication du dispositif lumineux liés à une pièce rapportée sont alors éliminés.

Le module lumineux selon l'invention peut optionnellement présenter une ou plusieurs caractéristiques suivantes :
- une source lumineuse est fixée sur le substrat,
- la source lumineuse est une source à semi-conducteur, c'est-à-dire une diode électroluminescente, communément désignée par l'abréviation DEL ou par l'abréviation anglo-saxonne LED (Light Emitting Diode).,
- une pièce optique est fixée sur le substrat,
- la pièce optique comporte une lentille,
- la pièce optique dévie un faisceau lumineux issu de la source lumineuse,
- la source lumineuse est une LED de type montée sur embase (ce type de technologie est communément désigné par l'expression anglo-saxonne "submount", la LED est donc dite "montée en submount") , ci-après "LED sur embase",
- ladite LED sur embase est directement solidarisée sur la surface de la pièce formant masse,
- ladite LED sur embase est directement solidarisée sur une pièce optique fixée sur le substrat,
- ladite LED sur embase est positionnée de sorte à ce qu'une lumière émise par la LED sur embase traverse une ouverture traversante du substrat,
- ladite LED sur embase est raccordée à des pistes électriques du substrat par des liaisons filaires, selon la technologie communément désignée par l'expression anglo-saxonne "wire-bonding",
- ladite LED sur embase coopère avec ladite pièce optique fixée sur le substrat,
- la pièce formant masse est un dissipateur thermique,
- ladite pièce formant masse est un dissipateur thermique sur lequel est positionnée ladite LED sur embase,
- ladite pièce formant masse est un dissipateur thermique sur lequel est positionnée ladite LED sur embase, ladite LED sur embase coopérant avec la pièce optique fixée sur le substrat,
- ladite pièce formant masse comporte une partie à l'intérieur du module et une partie à l'extérieur du module,
- ledit dissipateur thermique est fixé sur un châssis du dispositif lumineux,
- ledit dissipateur thermique est réalisé en matière métallique ; cela accroît son efficacité,
- ladite matière métallique est à base d'aluminium ; cela est avantageux tant pour la dissipation thermique et le poids de la pièce en question, que d'un point de vue économique,
- ledit châssis est réalisé en matière plastique ; cela est avantageux d'un point de vue économique,
- ledit châssis est surmoulé sur le dissipateur thermique ; cela permet de réaliser de façon idéale une étanchéité du module lorsque le dissipateur thermique possède une partie à l'intérieur et une partie à l'extérieur du module lumineux,
- un système optique est agencé pour dévier un faisceau lumineux issu de la source lumineuse et/ou de la pièce optique ; de la sorte, une efficacité lumineuse du dispositif lumineux est améliorée,
- une position dudit système optique est indépendante de la déformation du substrat ; de la sorte, une efficacité lumineuse du dispositif lumineux est améliorée,
- le dissipateur thermique est en contact thermique avec la LED et/ou la pièce optique fixée au substrat,
- un conducteur thermique est apposé sur une aire du substrat excluant une zone de contact des pistes électriques avec le dissipateur thermique ; de la sorte, le contact thermique entre le substrat et le dissipateur thermique est réalisé sans créer de contact électrique indésirable entre des pistes du substrat et la pièce formant masse,
- le conducteur thermique est par exemple une pâte thermique ou une graisse thermique,
- la languette comporte au moins un dépôt de matière conductrice sur au moins une partie des pistes de la languette en contact électrique avec la pièce formant masse ; ce dépôt a pour effet technique de préserver les pistes de la languette d'une usure liée au contact mécanique avec la pièce formant masse,
- ledit dépôt de matière électriquement conductrice est un dépôt d'une matière métallique ; de la sorte une usure du dépôt de matière est limitée,
- ledit dépôt de matière conductrice comporte de l'étain ; de la sorte un coût de réalisation du dépôt est diminué,
- le dépôt de matière électriquement conductrice sur au moins une partie des pistes de la languette en contact électrique avec la pièce formant masse constitue une protubérance ; cela a pour effet de faciliter le contact mécanique avec la pièce formant masse,
- la pièce formant masse comporte au moins une protubérance agencée pour assurer le contact électrique au moins une partie des pistes de la languette,
- ladite protubérance de la pièce formant masse est réalisée sans ajout de matière, par exemple elle est directement issue du moulage, de l'usinage, du forgeage, ou d'autres opérations sans ajout de matière réalisées sur la pièce formant masse,
- la découpe est un évidement sur un rebord du substrat ; de la sorte, la languette peut être formée sur un rebord du substrat,
- la découpe est un évidement d'une partie du substrat non adjacente à un rebord du substrat ; de la sorte, la languette peut être formée sur une partie du substrat non adjacente à un rebord du substrat,
- la découpe est une fente, c'est à dire qu'elle est étroite ; de la sorte la réalisation de la découpe nécessite d'éliminer moins de surface sur le substrat, qui est coûteux; lorsque la fente est étroite, un espace disponible pour des composants électroniques est donc maximisé, et un coût de fabrication du substrat est donc diminué,
- de préférence, la distance d'un bord à l'autre de la fente est de l'ordre de grandeur de l'épaisseur du substrat ; de la sorte l'épaisseur du substrat ne gêne pas un mouvement engendré par une flexion de la languette ; en effet la friction dans une fente trop étroite pourrait gêner ou empêcher ce type de mouvement,
- la languette s'étend entre une base et une extrémité libre, la base étant adjacente à un moyen de fixation du substrat sur un châssis du dispositif lumineux ; de la sorte, la déformation de la languette n'a pas d'effet sur les autres régions du substrat, notamment celles comportant la LED et/ou la pièce optique,
- le moyen de fixation est situé dans une région centrale du substrat,
- le moyen de fixation est une vis,
- le moyen de fixation est un pion de bouterollage,
- le substrat est un circuit imprimé, aussi désigné par l'abréviation anglo-saxonne "PCB" (Printed Circuit Board),
- le substrat est un PCB multicouches comportant au moins 3 couches de pistes électriques,
- une couche de pistes électriques du PCB multicouches située du côté de la pièce formant masse est dédiée à la mise à la masse,
- le substrat est réalisé en époxy, en particulier en époxy de type FR4,
- le dispositif lumineux est un feu antibrouillard avant,
- le dispositif lumineux est un feu de croisement, un feu de route, un feu de position, un feu d'éclairage diurne, un feu arrière, un feu antibrouillard arrière ou un feu stop,
- le dispositif lumineux est un dispositif d'éclairage de l'intérieur du véhicule.

Une matière est électriquement conductrice lorsqu'une conductivité électrique mesurée d'une telle matière est proche de la conductivité électrique d'alliages à base d'étain et/ou de cuivre et/ou d'or et/ou de platine et/ou de fer. Une matière n'est au contraire pas électriquement conductrice lorsqu'une conductivité électrique mesurée d'une telle matière est proche de celle d'un substrat en époxy.

D'autres caractéristiques et avantages de l'invention apparaîtront à la lecture de la description détaillée d'un mode de réalisation qui va suivre et pour la compréhension de laquelle on se reportera aux dessins annexes :
- la figure 1 est une vue en perspective d'un dispositif lumineux de véhicule automobile selon l'invention, dans lequel une LED 3 est fixée sur le substrat 2 et la pièce formant masse 4 est un dissipateur thermique en contact thermique avec la LED 3,
- la figure 2a est une vue de dessus d'une languette (7) formée par une découpe d'un bord du substrat (2),

- la figure 2b est une vue de dessus d'une languette (7) formée par une découpe (6) d'un bord du substrat (2), ladite découpe formant une fente,
- la figure 2c est une vue de dessus d'une languette (7) formée par une découpe non adjacente à un bord du substrat, ladite découpe formant une fente,

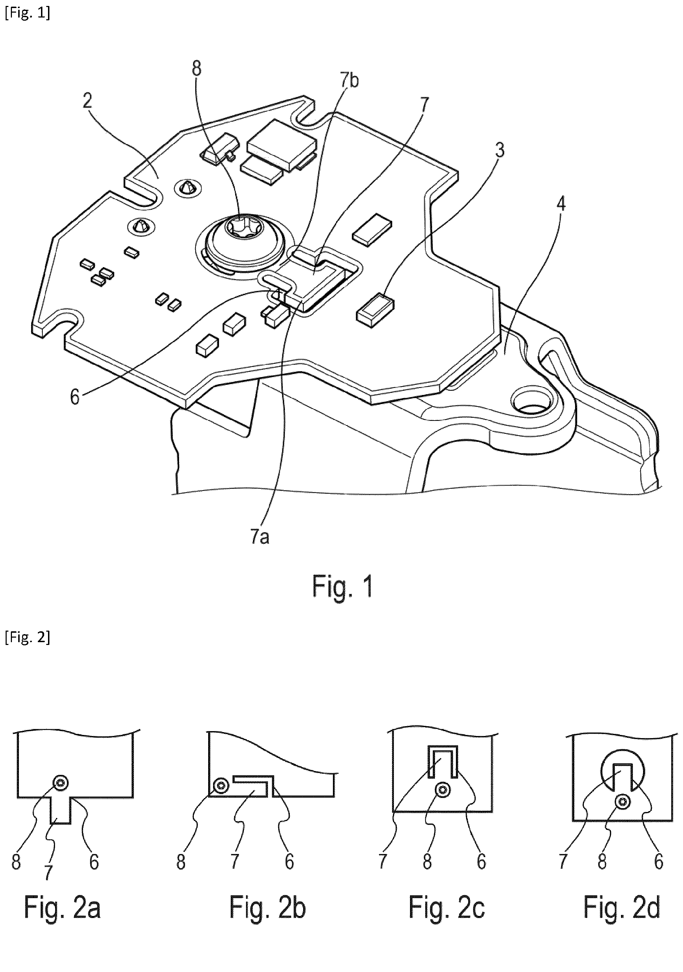

- la figure 2c est une vue de dessus d'une languette (7) formée par une découpe non adjacente à un bord du substrat, ladite découpe ne formant pas une fente,

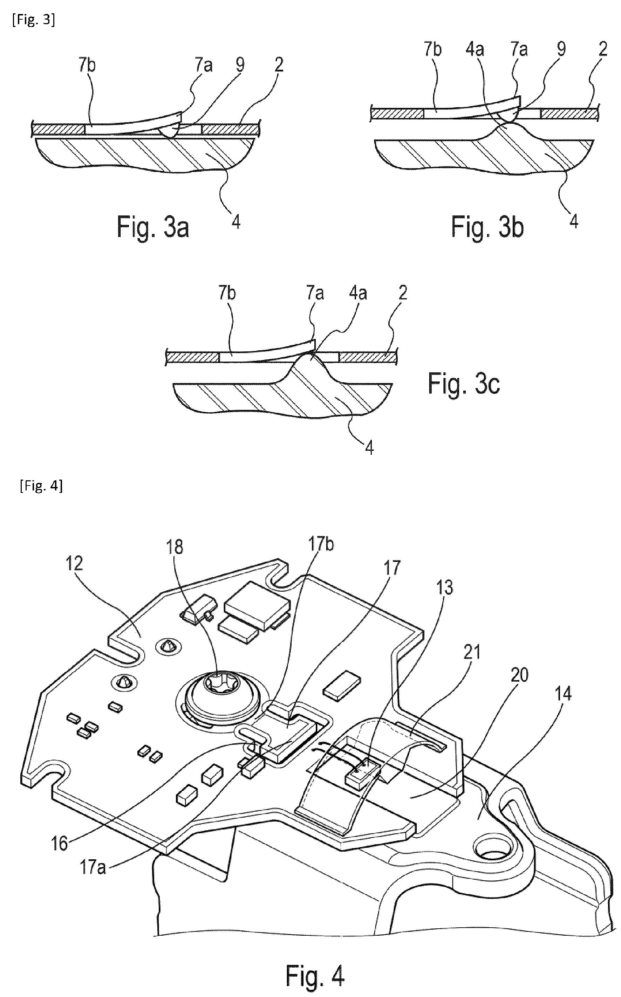

- la figure 3a montre une languette (7) comportant une base (7b) et une extrémité libre (7a) sur laquelle a été effectué un dépôt d'étain formant une protubérance (9),
- la figure 3b montre une languette (7) comportant une base (7b) et une extrémité libre (7a) sur laquelle a été effectué un dépôt d'étain formant une protubérance (9), assurant le contact électrique avec une pièce formant masse (4) comportant une protubérance (4a),
- la figure 3c montre une languette (7) comportant une base (7b) et une extrémité libre (7a) sur laquelle a été effectué un dépôt d'étain formant une protubérance (9),
- la figure 4 est une vue en coupe d'un dispositif selon l'invention dans lequel une LED est montée sur embase solidarisée sur le dissipateur thermique et une pièce optique est fixée au substrat,

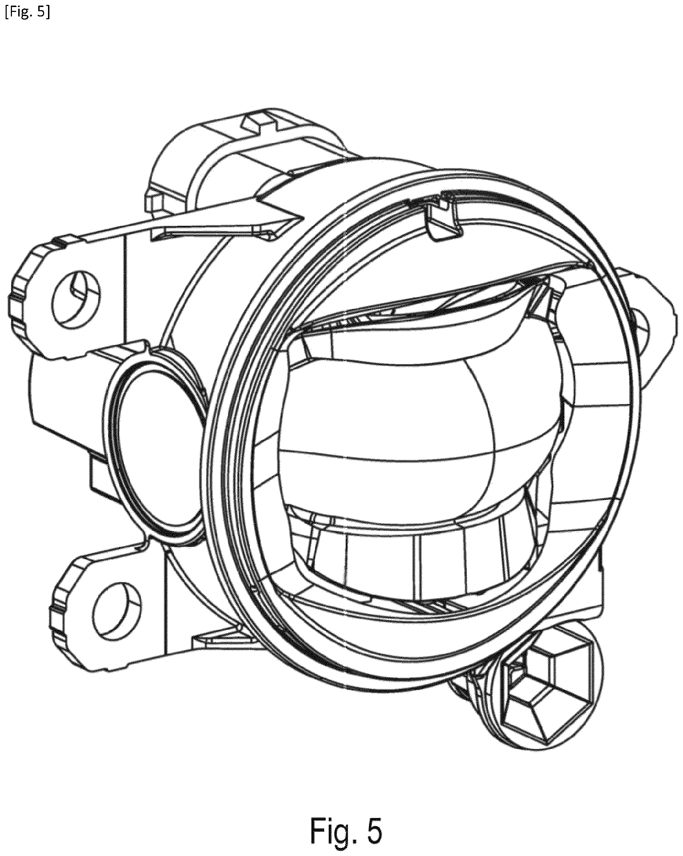

- la figure 5 est une vue en perspective d'un feu antibrouillard selon l'invention.

Un dispositif lumineux (1) comporte un substrat (2), une pièce formant masse (4), et une LED (3), ladite LED (3) étant fixée sur le substrat (2). Le substrat comporte une découpe (6) formant une languette (7).

Dans un mode de réalisation préféré illustré sur la figure 1, la pièce formant masse (4) est un dissipateur thermique formé d'un élément en aluminium, en contact thermique avec la LED (3).

Dans le mode de réalisation illustré sur la figure (1), le châssis (5) du dispositif lumineux (1) est surmoulé sur la pièce formant masse (4). La découpe (6) est un évidement formant une languette (7), qui comporte une base (7b) et une extrémité libre (7a). La base (7b) est adjacente à un moyen de fixation (8) du substrat sur le châssis (5), constitué d'une vis. Le dispositif comprend un système optique (non représenté) agencé pour dévier des rayons lumineux émis par la LED (3). Ledit système optique est fixé au châssis (5) du dispositif lumineux (1) : une position dudit système optique est donc ici indépendante des déformations du substrat.

Dans le mode de réalisation illustré sur la figure 3a, la languette (7) comportant une base (7a) et une extrémité libre (7b) comporte un dépôt d'étain (9) formant une protubérance. La pièce formant masse (4) comporte une protubérance (4a) qui coopère avec le dépôt d'étain (9) pour assurer le contact électrique entre avec au moins l'une des pistes électriques de la languette (7) et le dissipateur thermique (4).

Dans le mode de réalisation illustré sur la figure 3b, la languette (7) comportant une base (7a) et une extrémité libre (7b) ne comporte pas de protubérance. La pièce formant masse (4) comporte une protubérance (4a) qui coopère avec l'extrémité libre (7b) de la languette pour assurer le contact électrique entre au moins l'une des pistes électriques de la languette (7) et le dissipateur thermique (4).

Dans le mode de réalisation illustré sur la figure 3c, la languette (7) comportant une base (7a) et une extrémité libre (7b) comporte un dépôt (9) d'étain formant une protubérance. La pièce formant masse (4) ne comporte pas de protubérance ; c'est une surface plane qui coopère l'extrémité libre (7b) de la languette pour assurer le contact électrique entre au moins l'une des pistes électriques de la languette (7) et le dissipateur thermique (4). Dans l'ensemble des modes de réalisation illustrés sur les figures 1 à 3b, la languette formée par la découpe (6) est déformée de sorte à garantir le contact électrique d'une piste électrique sur une extrémité libre de la languette (7a) avec le dissipateur thermique (4), et la base (7b) de la languette est maintenue sur le châssis par la vis de fixation (8). De la sorte, la déformation de la languette (7) ne provoque pas de déformation du substrat : un déplacement vertical de la LED (3) est ainsi limité et une perte d'efficacité lumineuse du module (1) est ainsi évitée.

Dans le mode de réalisation illustré sur la figure 4, la pièce formant masse est un dissipateur thermique (14) et la source lumineuse est une LED (13) montée sur embase. Ladite LED (13) est solidarisée sur le dissipateur thermique (14), électriquement reliée à des pistes du substrat par des liaisons filaires, et émet de la lumière à travers une ouverture traversante (20) à travers le substrat (12). Une pièce optique (21) est fixée sur le substrat de sorte à dévier un faisceau lumineux émis par la LED (13). Le châssis (15) du dispositif lumineux (11) est surmoulé sur le dissipateur thermique (14). La découpe (16) est un évidement formant une languette (17), qui comporte une base (17b) et une extrémité libre (17a). La base (17b) est adjacente à un moyen de fixation (18) du substrat sur le châssis (15), constitué d'une vis. Un système optique (non représenté) est agencé pour dévier un faisceau lumineux issu de la pièce optique (21). Ledit système optique est fixé au châssis (15, non représenté) du dispositif lumineux (11) : une position dudit système optique est donc indépendante des déformations du substrat.

Dans le mode de réalisation illustré sur la figure 4 la languette formée par la découpe (6) est déformée de sorte à garantir le contact électrique d'une piste électrique sur une extrémité libre de la languette (7a) avec le dissipateur thermique (4), et la base (7b) de la languette est maintenue sur le châssis par la vis de fixation (8). De la sorte, la déformation de la languette (7) ne provoque pas de déformation du substrat : un déplacement vertical de la pièce optique (3) est ainsi limité et une perte d'efficacité lumineuse du module (1) est ainsi évitée.

La description qui précède explique clairement comment l'invention permet d'atteindre les objectifs qu'elle s'est fixée, et notamment d'éliminer les coûts de fabrication liés à l'utilisation d'une pièce rapportée pour assurer le contact entre le substrat et la pièce formant masse, tout en limitant la diminution d'un déplacement de la LED et/ou de la pièce optique et/ou de l'efficacité lumineuse.

## Revendications

1. Dispositif lumineux d'un véhicule automobile, comportant une source lumineuse (3;13) et/ou une pièce optique (21), un substrat (2;12) comportant des pistes électriques, ladite source lumineuse (3;13) et/ou pièce optique (21) étant fixée sur ledit substrat (2;12), une pièce formant une masse électrique (4,14) pour lesdites pistes électriques, le substrat (2;12) comportant une découpe (6;16) formant une languette (7;17), des pistes électriques du substrat (2;12) se prolongeant sur ladite languette (7;17), au moins une desdites pistes sur ladite languette (7;17) étant en contact électrique avec la pièce formant masse (4;14),
**caractérisé en ce que** le contact de la languette avec la pièce formant masse est maintenu par déformation élastique de la languette.

2. Dispositif lumineux selon la revendication 1, **caractérisé en ce que** la pièce formant masse (4;14) est un dissipateur thermique.

3. Dispositif lumineux selon l'une quelconque des revendications précédentes, **caractérisé en ce que** la languette comporte au moins un dépôt (9) d'une matière électriquement conductrice sur au moins une partie des pistes de la languette en contact électrique avec la pièce formant masse.

4. Dispositif lumineux selon la revendication 3, **caractérisé en ce que** ledit dépôt (9) forme une protubérance.

5. Dispositif lumineux selon l'une quelconque des revendications précédentes, **caractérisé en ce que** la pièce formant masse (4;14) comporte au moins une protubérance (4a) agencée pour assurer le contact électrique avec au moins une partie des pistes de la languette.

6. Dispositif lumineux selon l'une quelconque des revendications précédentes, **caractérisé en ce que** la découpe (6;16) est une fente.

7. Dispositif lumineux selon l'une quelconque des revendications précédentes, **caractérisé en ce que** la languette (7;17) s'étend entre une base (7b;17b) et une extrémité libre (7a;17a), la base étant adjacente à un moyen de fixation (8;18) du substrat sur un châssis (5;15) du dispositif lumineux.

8. Dispositif lumineux selon la revendication 7, **caractérisé en ce que** le moyen de fixation (8;18) est une vis.

9. Dispositif lumineux selon l'une quelconque des revendications précédentes, **caractérisé en ce qu'**il comprend un système optique est agencé pour dévier un faisceau lumineux émis par la source lumineuse (3;13) et/ou la pièce optique (21), une position dudit système optique étant indépendante des déformations du substrat (2;12).

10. Dispositif lumineux selon l'une quelconque des revendications précédentes, **caractérisé en ce que** le dispositif est un feu antibrouillard.

## Patentansprüche

1. Leuchtvorrichtung eines Kraftfahrzeugs, umfassend eine Lichtquelle (3;13) und/oder ein optisches Element (21), ein Substrat (2;12) mit elektrischen Leiterbahnen, wobei die Lichtquelle (3;13) und/oder das optische Element (21) auf dem Substrat (2;12) befestigt ist, ein Teil, das eine elektrische Masse (4,14) für die elektrischen Leiterbahnen bildet, wobei das Substrat (2;12) einen Ausschnitt (6;16) aufweist, der eine Lasche (7;17) bildet, wobei sich elektrische Leiterbahnen des Substrats (2;12) auf die Lasche (7;17) erstrecken, wobei mindestens eine der Leiterbahnen auf der Lasche (7;17) in elektrischem Kontakt mit dem massebildenden Teil (4;14) steht, **dadurch gekennzeichnet, dass** der Kontakt der Lasche mit dem massebildenden Teil durch elastische Verformung der Lasche aufrechterhalten wird.

2. Leuchtvorrichtung nach Anspruch 1, **dadurch gekennzeichnet, dass** das massebildende Teil (4;14) ein Wärmeableiter ist.

3. Leuchtvorrichtung nach einem der vorhergehenden Ansprüche, **dadurch gekennzeichnet, dass** die Lasche mindestens eine Beschichtung (9) aus einem elektrisch leitenden Material auf mindestens einem Teil der Leiterbahnen der Lasche aufweist, die in elektrischem Kontakt mit dem massebildenden Teil steht.

4. Leuchtvorrichtung nach Anspruch 3, **dadurch gekennzeichnet, dass** die Beschichtung (9) einen Vorsprung bildet.

5. Leuchtvorrichtung nach einem der vorhergehenden Ansprüche, **dadurch gekennzeichnet, dass** das massebildende Teil (4;14) mindestens einen Vorsprung (4a) aufweist,der angeordnet ist, um den elektrischen Kontakt mit mindestens einem Teil der Leiterbahnen der Lasche sicherzustellen.

6. Leuchtvorrichtung nach einem der vorhergehenden Ansprüche, **dadurch gekennzeichnet, dass** der Ausschnitt (6;16) ein Schlitz ist.

7. Leuchtvorrichtung nach einem der vorhergehenden Ansprüche, **dadurch gekennzeichnet, dass** sich die Lasche (7;17) zwischen einer Basis (7b;17b) und einem freien Ende (7a;17a) erstreckt, wobei die Basis an ein Befestigungsmittel (8;18) des Substrats auf einem Chassis (5;15) der Leuchtvorrichtung angrenzt.

8. Leuchtvorrichtung nach Anspruch 7, **dadurch gekennzeichnet, dass** das Befestigungsmittel (8;18) eine Schraube ist.

9. Leuchtvorrichtung nach einem der vorhergehenden Ansprüche, **dadurch gekennzeichnet, dass** sie ein optisches System umfasst, das angeordnet ist, um einen von der Lichtquelle (3;13) und/oder dem optischen Element (21) ausgesendeten Lichtstrahl abzulenken, wobei eine Position des optischen Systems unabhängig von den Verformungen des Substrats (2;12) ist.

10. Leuchtvorrichtung nach einem der vorhergehenden Ansprüche, **dadurch gekennzeichnet, dass** die Vorrichtung ein Nebelscheinwerfer ist.

## Claims

1. Lighting device of a motor vehicle, comprising a light source (3;13) and/or an optical part (21), a substrate (2;12) comprising electrical tracks, said light source (3;13) and/or optical part (21) being fixed on said substrate (2;12), a part forming an electrical ground (4,14) for said electrical tracks, the substrate (2;12) comprising a cutout (6;16) forming a tab (7;17), electrical tracks of the substrate (2;12) extending onto said tab (7;17), at least one of said tracks on said tab (7;17) being in electrical contact with the part forming ground (4;14), **characterized in that** the contact of the tab with the part forming ground is maintained by elastic deformation of the tab.

2. Lighting device according to claim 1, **characterized in that** the part forming ground (4;14) is a heat sink.

3. Lighting device according to any one of the preceding claims, **characterized in that** the tab comprises at least one deposit (9) of an electrically conductive material on at least a portion of the tracks of the tab in electrical contact with the part forming ground.

4. Lighting device according to claim 3, **characterized in that** said deposit (9) forms a protrusion.

5. Lighting device according to any one of the preceding claims, **characterized in that** the part forming ground (4;14) comprises at least one protrusion (4a) arranged to ensure electrical contact with at least a portion of the tracks of the tab.

6. Lighting device according to any one of the preceding claims, **characterized in that** the cutout (6;16) is a slot.

7. Lighting device according to any one of the preceding claims, **characterized in that** the tab (7;17) extends between a base (7b;17b) and a free end (7a;17a), the base being adjacent to a means of attachment (8;18) of the substrate to a chassis (5;15) of the lighting device.

8. Lighting device according to claim 7, **characterized in that** the means of attachment (8;18) is a screw.

9. Lighting device according to any one of the preceding claims, **characterized in that** it comprises an optical system arranged to deflect a light beam emitted by the light source (3;13) and/or the optical part (21), a position of said optical system being independent of deformations of the substrate (2;12).

10. Lighting device according to any one of the preceding claims, **characterized in that** the device is a fog light.
